# DEMANDE DE BREVET EUROPEEN

(11) **EP 3 783 643 A1**
(43) Date de publication de la demande: **24.02.2021**
(21) Numéro de dépôt: 20188404.6
(22) Date de dépôt: 29.07.2020
(51) Int. Cl.: H01L 21/8234, H01L 29/66, H01L 21/311, H01L 21/223, H01L 21/28, H01L 29/78, H01L 21/02, H01L 21/3115

(54) **PROCÉDÉ DE FABRICATION DE COMPOSANTS MICROÉLECTRONIQUES**

(30) Priorité: 23.08.2019 FR 1909377
(71) Demandeur: Commissariat à l'Energie Atomique et aux Energies Alternatives, 75015 Paris (FR)
(72) Inventeur: POSSEME, Nicolas, 38054 GRENOBLE CEDEX 09 (FR)
(74) Mandataire: Decobert, Jean-Pascal

(57) **Abrégé**

L'invention concerne un procédé de réalisation d'un composant à base d'une pluralité de transistors sur un substrat. Le substrat comprend des zones d'isolation électrique (12) qui peuvent être le lieu de court-circuit lors du dépôt d'une couche mécaniquement contraignante (15). Pour y remédier, il est proposé de limiter le rapport de forme des espaces entre les transistors, notamment au niveau de cavités qui se forment au cours des étapes de fabrication à ce niveau, par un enlèvement sélectif du matériau d'un revêtement de protection (24) appliqué sur des espaceurs des grilles de transistors.

## Description

### DOMAINE TECHNIQUE

La présente invention concerne le domaine de la fabrication de composants micro-électroniques. Elle trouvera pour application avantageuse mais non limitative la fabrication de composants à base de transistors, ces composants permettant par exemple de former des circuits CMOS (Complementary Metal Oxide Semiconductor) ou des mémoires volatiles telles que les mémoire Flash ou des mémoires non volatiles telles que les mémoires SRAM (Static Random Access Memory).

### ÉTAT DE LA TECHNIQUE

Dans le domaine considéré ci-dessus, on connaît des technologies de fabrication de transistors basés sur des substrats de diverses technologies. Il peut s'agir de substrats de type SOI (acronyme de Silicon On Insulator) comprenant une couche sous-jacente de semi-conducteur (souvent du silicium), surmontée d'une couche d'oxyde dite BOX, puis d'une couche surfacique de semi-conducteur, tel du silicium monocristallin. Un raffinement des substrats SOI est la technologie FDSOI (en anglais Fully Depleted Silicon On Insulator) qui correspond à un support du type couche superficielle d'une plaque de silicium sur isolant totalement déplétée.

Un type simple de substrats est de type massif, dénommés en anglais « bulk ». Ces substrats comprennent globalement une base en matériau semi-conducteur, typiquement du silicium, et des zones électriquement isolantes, typiquement en dioxyde de silicium. Les zones électriquement isolantes sont exposées au niveau d'une des faces du substrat et délimitent des zones exposées faites du matériau semi-conducteur. Ainsi, les zones électriquement isolantes ont une fonction de séparation électrique entre différentes zones de matériau semi-conducteur, encore dénommées zones actives. Ces zones actives sont le lieu de fabrication de transistors. Il est en particulier connu de fabriquer les zones d'isolation électrique par la réalisation de tranchées latérales d'isolation dites STI, acronyme de l'anglais « shallow trench isolation » c'est-à-dire « tranchées d'isolation peu profondes ».

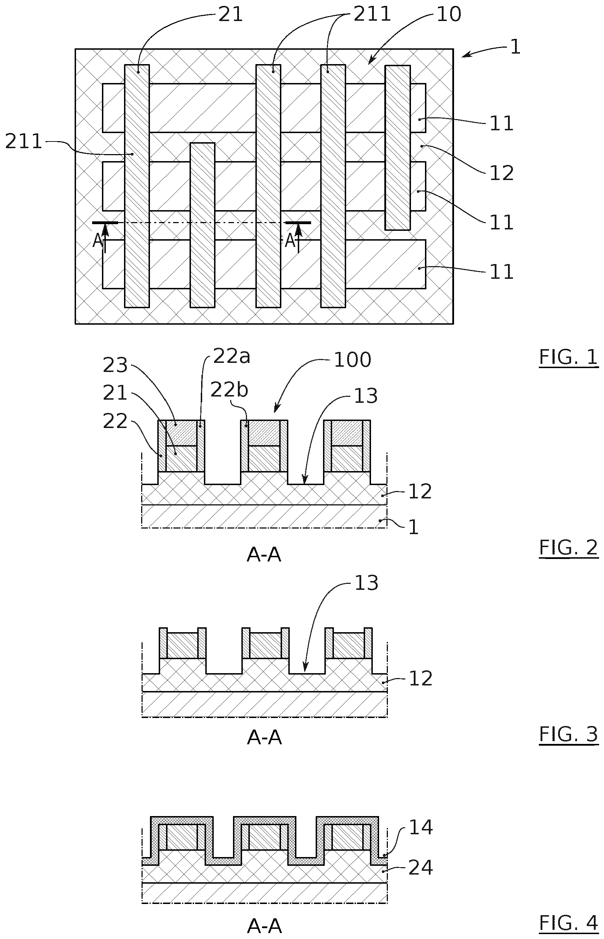

Dans ce contexte, la figure 1 présente en vue de dessus un schéma d'un substrat 1 doté, sur une première face 10, de zones exposées comprenant des zones actives 11 et des zones d'isolation électrique 12. Des grilles de transistors 21 peuvent être formées sur la base de barreaux dirigés perpendiculairement à l'orientation longitudinale des zones actives 11.

On sait par ailleurs que la réalisation de composants CMOS peut nécessiter l'ajout de couches permettant d'apporter de la contrainte (en compression ou respectivement en tension) permettant d'accroître les performances des dispositifs, en particulier des transistors à effet de champ (de type P ou respectivement N). Ces couches de contraintes sont aussi appelées « stress liner » ou CESL (Contact Etch Stop Liner). Leur efficacité dépend de l'épaisseur de la couche, souvent réalisée à base de nitrure de silicium. Mais leur dépôt provoque des défauts de remplissage qui se traduisent par la mise en court-circuit de composants micro-électroniques voisins.

Les figures 2 à 7B expliquent ces défauts. Elles représentent des vues en coupe au niveau de la ligne A-A de la figure 1, de sorte à montrer l'impact des étapes de fabrication sur les zones d'isolation électrique. Elles présentent de manière résumée des phases successives de fabrication de composants.

À la figure 2, on a fabriqué, sur la base du substrat 1, des grilles 21 (généralement en polysilicium avec une couche électriquement isolante sous-jacente, typiquement d'oxyde, non représentée sur les figures). Par ailleurs, à ce stade, des espaceurs 22 ont été formés par un dépôt de couche d'espaceurs, typiquement du nitrure de silicium, et une gravure, avec les techniques bien connues de photolithographie et de gravure. Un masque dur 23 surplombe la grille 21 des transistors durant cette étape qui comporte aussi la fabrication de zones de sources/drains sur des portions de la zone active où le transistor est présent, ces portions étant adjacentes à la grille du transistor. Cette fabrication implique des dopages successifs, de type N et de type P pour former les deux natures de transistors des technologies CMOS. Durant ces étapes, la zone d'isolation électrique 12 est affectée de sorte qu'une zone consommée 13 apparaît à sa surface, sous forme de reliefs en creux. Cette zone consommée 13 est dénommée cavité par la suite.

De même, l'étape de retrait du masque dur 23 présentée à la figure 3 aggrave la consommation du matériau de la zone d'isolation électrique 12 au niveau de la cavité 13. Le matériau formant la zone d'isolation électrique 12 est appelé matériau diélectrique dans la suite.

Une étape suivante peut être le dépôt d'un revêtement de protection des grilles, sous forme d'une couche 14, par exemple de nitrure de silicium, tel qu'illustré en figure 4.

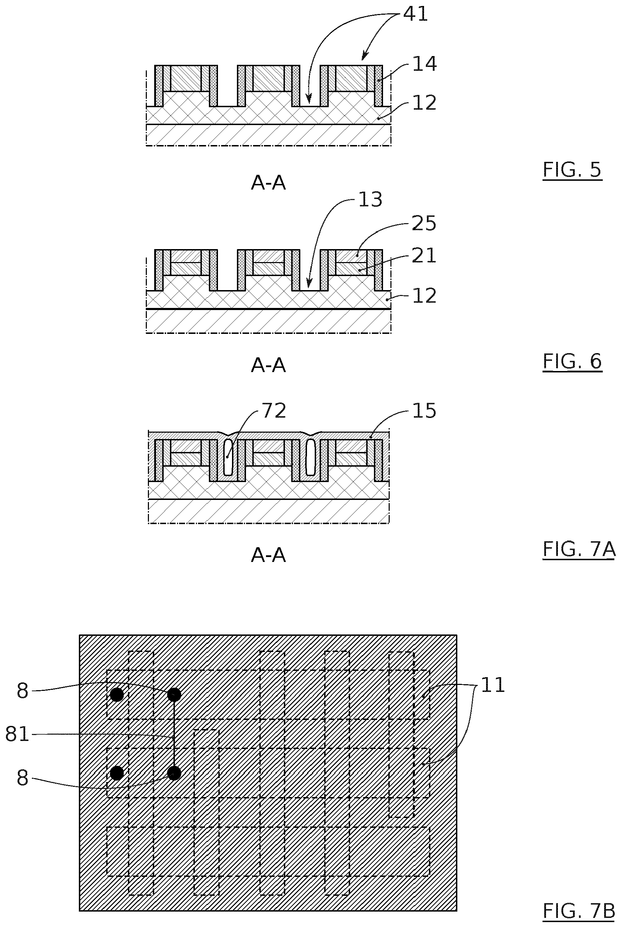

Comme le montre la figure 5, cette protection doit ensuite être retirée sélectivement sur les parties horizontales pour dégager le haut de la grille et la surface des zones d'isolation, avec des ouvertures 41 dans la couche de protection 14, tout en préservant un revêtement de protection sur les espaceurs 22. Cette étape induit une consommation supplémentaire du matériau diélectrique.

Des étapes suivantes sont présentées à la figure 6 avec une siliciuration d'une portion 25 du haut de la grille 21. Cette portion siliciurée 25 réduit la résistance de contact ; elle est encore ici appelée module de contact. Il peut s'agir de siliciure de nickel.

À noter que ces étapes incluent généralement un ou plusieurs traitements thermiques ainsi que des phases de nettoyage également dommageables à l'intégrité du matériau diélectrique.

Finalement, une couche mécaniquement contraignante 15 peut être déposée. Compte tenu de la consommation indésirable du matériau diélectrique de la zone 12 entre deux transistors adjacents, le rapport de forme des cavités 13 est augmenté ce qui pénalise la fiabilité du remplissage des espaces entre deux transistors adjacents. La figure 7A révèle que des vides 72 peuvent subsister au sein même de la couche mécaniquement contraignante 15. Ces vides 72 résiduels ne peuvent malheureusement pas être remplis par d'autres couches au-dessus de la couche mécaniquement contraignante 15, telle qu'une couche supérieure d'isolant électrique généralement en dioxyde de silicium. Ce défaut de remplissage est d'autant plus critique que l'étage de transistors ainsi constitué est noyé en milieu de ligne (de l'anglais « middle of line ») d'un dispositif micro-électronique complet.

Les vides 72 résiduels ainsi formés s'étendent typiquement le long des barreaux transversaux 211 de grilles, d'une zone active 11 à l'autre. Cela peut avoir des conséquences néfastes lorsqu'un de ces vides 72 est ouvert lors d'une formation ultérieure des contacts électriques, en particulier lorsqu'un problème d'alignement de ces contacts survient. Dans ce cas, lors du dépôt du matériau conducteur (par exemple du tungstène), notamment par dépôt chimique en phase vapeur, le vide 72 ainsi ouvert se trouve comblé par le matériau conducteur et crée un court-circuit entre deux zones de contact de deux zones actives adjacentes qui ne sont pas censées être connectées électriquement. La figure 7B révèle de manière schématique deux éléments de contact 8 présents sur des zones actives 11 adjacentes et reliés par une zone de court-circuit 81 formée de manière indésirable au travers d'un vide résiduel lié à un défaut de remplissage de la couche mécaniquement contraignante 15.

Au regard de ces inconvénients, il est actuellement nécessaire de préserver un espace important entre deux transistors adjacents ce qui implique généralement une limitation de densité d'implantation des transistors sur le substrat. Même sans considérer le dépôt d'une couche contraignante, il existe par ailleurs le besoin de disposer d'un espace optimisé entre deux transistors adjacents.

Il existe par conséquent un besoin d'améliorer les techniques de fabrication de composants micro-électroniques actuelles.

La présente invention a notamment pour objet un procédé de réalisation de composant à base de transistors supprimant ou limitant l'apparition de vides résiduels dans les zones d'isolation électrique.

### RÉSUMÉ

Un aspect concerne un procédé de réalisation d'un composant à base d'une pluralité de transistors, sur un substrat comprenant au moins une zone active et une zone d'isolation électrique, chaque transistor de la pluralité de transistors comprenant une grille, des espaceurs sur les flancs de la grille et un module de contact sur une face supérieure de la grille, l'au moins une zone d'isolation électrique comprenant au moins une cavité formée en creux entre un espaceur d'un premier transistor de la pluralité de transistors et un espaceur d'un deuxième transistor de la pluralité de transistors, lesdits premier transistor et deuxième transistor étant adjacents.

Le procédé comprend :
- une formation d'une zone de grille des transistors,
- une formation des espaceurs,
- une formation d'un revêtement de protection configuré pour recouvrir au moins en partie les espaceurs et une portion de flanc des cavités, sans recouvrir une face supérieure de la zone de grille et une portion de base des cavités (par exemple en ayant fait l'objet d'une ouverture gravée par plasma à cet endroit),
- une formation du module de contact dans une portion supérieure de la zone de grille à partir de la face supérieure, la grille se trouvant dans une portion de la zone de grille sous-jacente au module de contact.

Avantageusement, le procédé comprend, après la formation du module de contact, un enlèvement d'au moins une partie du revêtement de protection, avec :
- une implantation isotrope d'ions légers configurée pour former des parties superficielles modifiées dans l'épaisseur, respectivement, du module de contact, du revêtement de protection et de la portion de base de la cavité ;
- une application d'un plasma comprenant au moins un mélange de composants gazeux, l'application d'un plasma étant configurée pour :
   - graver la partie superficielle modifiée du revêtement de protection de sorte à ne préserver, dans le revêtement de protection, qu'une partie résiduelle du revêtement de protection ;
   - former une couche à base d'un oxyde de silicium sur les surfaces exposées, respectivement, du module de contact, de la cavité et du revêtement de protection, et pour que la couche d'un oxyde de silicium soit plus épaisse sur la surface exposée du module de contact et sur celle de la cavité que sur la surface exposée du revêtement de protection.

Ce procédé fournit ainsi une solution permettant de réduire le rapport de forme des parties de la zone d'isolation électrique située entre deux transistors adjacents, grâce à un enlèvement de parties latérales du revêtement de protection. En élargissant l'espace entre les transistors, en particulier au niveau des cavités formées en creux dans la zone électriquement isolante par les étapes de fabrication successives, le risque de formation de vides lors du dépôt de la couche mécaniquement contraignante est réduit ou supprimé.

Un remplissage ultérieur, notamment par le « stress liner », des espaces entres les grilles est ainsi amélioré. Les vides résiduels sont évités.

Suivant un aspect avantageux, la phase d'implantation permet de rendre la portion modifiée du revêtement de protection fort sensible à la gravure ultérieure, lors de l'application du plasma. Le caractère isotrope de l'implantation assure que le revêtement de protection est aussi bien modifié que les parties horizontales du dispositif.

Suivant un autre aspect avantageux, la phase d'application d'un plasma produit une couche d'oxyde de silicium qui se développe plus préférentiellement sur les parties horizontales, en particulier au niveau de la surface exposée du module de contact et du fond de la cavité. Ces zones se trouvent donc rapidement protégées, car recouvertes d'une couche que l'on peut apparenter à une couche de passivation. Dans le même temps, les parties verticales, ici essentiellement au niveau du revêtement de protection, ne sont pas le lieu de création d'une couche d'oxyde de silicium, ou bien moins ; de ce fait, ces parties sont attaquées efficacement par là où les espèces du plasma gravent le matériau du revêtement de protection, typiquement du nitrure de silicium.

On comprend que la protection des parties horizontales permet d'obtenir une très forte sélectivité de la gravure lors de l'application du plasma. En outre, même si ce dernier est éventuellement fort anisotrope, cela n'impacte pas son efficacité pour cibler les parties verticales, c'est-à-dire le revêtement de protection à éliminer.

Dans un mode de réalisation avantageux, mais non limitativement, on réalise ensuite :
- une implantation isotrope d'ions légers additionnelle, configurée pour supprimer la couche à base d'un oxyde de silicium sur la surface exposée du revêtement de protection tout en préservant au moins une partie de l'épaisseur de la couche à base d'un oxyde de silicium sur la surface exposée du module de contact et sur celle de la cavité, et configurée pour former une nouvelle partie superficielle modifiée de la surface exposée de la partie résiduelle du revêtement de protection ;
- une application additionnelle du plasma, configurée pour graver la nouvelle partie superficielle modifiée de la partie résiduelle du revêtement de protection, de manière sélective relativement aux parties modifiées de la couche d'un oxyde de silicium, respectivement, sur la surface exposée du module de contact et sur celle de la cavité.

Suivant un aspect avantageux non limitatif, au moins un cycle d'implantation isotrope, et d'application du plasma est réalisé de manière additionnelle de sorte à éliminer au maximum, voire totalement le revêtement de protection, de proche en proche. Cette réitération assure une consommation latérale progressive et précise du matériau du revêtement de protection. Par exemple, cela permet de l'éliminer sans consommer, ou très peu, le matériau des espaceurs.

Des modes de réalisation concernent aussi des composants obtenus par les aspects décrits du procédé.

### BRÈVE DESCRIPTION DES FIGURES

Des buts, objets, ainsi que les caractéristiques et avantages ressortiront mieux de la description détaillée d'un mode de réalisation qui est illustré par les dessins d'accompagnement suivants dans lesquels :
La figure 1 illustre schématiquement, en vue de dessus, un substrat comprenant des zones actives et des zones d'isolation électrique adjacentes, sur lesquelles sont disposées des grilles de transistors.
La figure 2 illustre schématiquement en coupe transverse une étape de formation des espaceurs de grille, selon l'état de la technique.
La figure 3 illustre schématiquement en coupe transverse une étape de retrait de masque dur, ultérieure à celle de la figure 2, selon l'état de la technique.
La figure 4 illustre schématiquement en coupe transverse une étape de dépôt d'une couche de protection, ultérieure à celle de la figure 3, selon l'état de la technique.
La figure 5 illustre schématiquement en coupe transverse une étape de gravure anisotrope, ultérieure à celle de la figure 4, selon l'état de la technique.
La figure 6 illustre schématiquement en coupe transverse une étape de siliciuration, ultérieure à celle de la figure 5, selon l'état de la technique.
La figure 7A illustre schématiquement en coupe transverse une étape de formation d'une couche mécaniquement contraignante, ultérieure à celle de la figure 6, selon l'état de la technique.
La figure 7B présente une vue de dessus schématisant un court-circuit entre deux contacts électriques.
La figure 8 illustre une situation intermédiaire lors de la fabrication du composant à transistors, avec la présence d'un revêtement de protection.
La figure 9 illustre une étape du procédé modifiant partiellement les matériaux exposés.
La figure 10 illustre une étape du procédé suivant celle de la figure 9 produisant une couche d'oxyde et un enlèvement partiel du revêtement de protection.
La figure 11 illustre un accroissement de la couche d'oxyde s'opérant de manière préférentielle sur les parties horizontales.
La figure 12 illustre une configuration possible de la zone d'isolation électrique avant le dépôt d'une couche mécaniquement contraignante.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches ne sont pas représentatives de la réalité.

### DESCRIPTION DÉTAILLÉE

Avant d'entamer une revue détaillée de modes de réalisation, il est rappelé que le procédé peut comprendre notamment les caractéristiques optionnelles ci-après pouvant être utilisées en association ou alternativement :
- on opère au moins un cycle supplémentaire d'opération de l'implantation isotrope additionnelle et de l'application additionnelle ;
- on utilise un plasma dans lequel le mélange de composants gazeux comprend au moins un premier composant gazeux et un deuxième composant gazeux, et le premier composant gazeux est configuré pour graver la partie superficielle modifiée du revêtement de protection de sorte à ne préserver, dans le revêtement de protection, qu'une partie résiduelle du revêtement de protection, et dans lequel le deuxième composant gazeux est configuré pour graver au moins une partie de la partie résiduelle du revêtement de protection ;
- le deuxième composant gazeux comprend au moins une espèce fluorocarbonée;
- l'au moins une espèce fluorocarbonée comprend au moins une espèce hydrofluorocarbonée ;
- le premier composant gazeux comprend du SiCI4 et/ou du SiF4 ;
- le mélange de composants gazeux comprend en outre du dioxygène ;
- après l'enlèvement d'au moins une partie du revêtement de protection, on réalise une formation d'une couche mécaniquement contraignante pour les transistors
- le procédé est configuré pour enlever entièrement le revêtement de protection avant la formation de la couche mécaniquement contraignante ;
- les ions légers comprennent des espèces choisies parmi des ions à base d'hydrogène et/ou d'hélium ;
- l'implantation isotrope est effectuée par l'application d'un plasma comprenant les ions légers à une pression supérieure ou égale à 100 milli Torr, soit 0,1 x (101325/760)Pa, sous une température inférieure ou égale à 100 °C ;
- la durée d'implantation isotrope est inférieure ou égale à 30 secondes, et de préférence moins de 10 secondes ;
- le revêtement de protection est formé à base de nitrure de silicium ;
- le module de contact est formé en un siliciure métallique ;
- la zone d'isolation électrique (12) est formée en dioxyde de silicium ;
- après l'enlèvement d'au moins une partie du revêtement de protection et avant la formation de la couche mécaniquement contraignante, on opère une gravure configurée pour supprimer la couche d'un oxyde de silicium ;
- l'implantation isotrope, l'application du plasma, l'implantation isotrope additionnelle et l'application additionnelle du plasma sont opérées dans un même réacteur.

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON). La couche à base d'un oxyde de silicium formé par le plasma peut comprendre au moins 50% de cet oxyde, voire n'être qu'une couche consistant en cet oxyde.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les STI et les espaceurs sont typiquement formés en un matériau diélectrique.

Les termes « motif de grille », « empilement de grille », « grille » sont employés en synonymes.

Dans la présente demande de brevet, une cavité 13 correspond à un vide formé au sein de la zone d'isolation électrique 12, ce vide étant ouvert en surface de ladite zone d'isolation électrique 12, ce vide s'étendant en outre entre deux espaceurs 22 de deux transistors respectifs adjacents, au droit desdits espaceurs 22. Le creux formé par la cavité 13 s'entend par rapport à un plan confondu avec l'interface zone d'isolation/grille.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principal de la couche, la hauteur et la profondeur sont prises selon une direction normale au plan de base du substrat. Dans le cas où la couche s'étend dans plusieurs directions, notamment lors de phases de construction d'espaceurs ou de revêtement de protection, l'orientation de l'épaisseur peut varier ; sur les flancs de la grille, par exemple, l'épaisseur des espaceurs ou du revêtement de protection est généralement parallèle au plan du substrat.

En général, mais non limitativement, un espaceur forme une bague autour de la grille, avec un contour fermé ; on pourrait donc parler d'un espaceur unique autour de la grille; cependant, les représentations en coupe, et les directions privilégiées des grilles, font que l'on parle aussi de paires d'espaceurs (ou premier et deuxième espaceurs), terminologie ici retenue.

Les termes « sensiblement », « environ », « de l'ordre de » signifient « à 10 % près » ou, lorsqu'il s'agit d'une orientation angulaire, « à 10° près ». Ainsi, une direction sensiblement normale à un plan signifie une direction présentant un angle de 90±10° par rapport au plan.

Pour déterminer la géométrie des transistors et la disposition des différentes couches, on peut procéder à des analyses de microscopie électronique, en particulier de Microscopie Electronique à Balayage (MEB) ou de Microscopie Electronique en Transmission (MET ou TEM).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de portions de faibles dimensions telles que les cavités remplies par le matériau de remplissage. Elle peut être mise en œuvre sur des coupes métallurgiques au sein d'un MEB ou d'un MET.

Ces techniques permettent notamment de déterminer s'il y a des vides résiduels dans les tranchées d'isolation et le cas échéant leurs dimensions.

La taille des vides résiduels et/ou des cavités remplies par un matériau de remplissage sont caractéristiques de la mise en œuvre du procédé. Ils peuvent donc être un indice de la mise en œuvre du procédé selon l'invention.

Le procédé de fabrication de transistors va maintenant être décrit en détail suivant un mode de réalisation indicatif.

Le procédé comprend une partie d'étapes de fabrication classiques de transistors visant à former sur un substrat, pour chacun des transistors, un motif ou une zone de grille 100 flanqué d'espaceurs 22. Les étapes des figures 1 à 6 peuvent notamment être effectuées. On peut s'y référer pour les étapes décrites immédiatement ci-dessous.

Le substrat 1 peut comprendre une partie dite massive ou « bulk » selon la terminologie anglo-saxonne, des zones actives 11 en matériau semiconducteur, et des zones d'isolation 12 en matériau diélectrique.

Le substrat peut également être de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator).

Dans tous les cas, les transistors sont formés sur des zones actives 11 et isolés électriquement par des zones d'isolation 12, typiquement des tranchées d'isolation de type STI (shallow trench isolation), généralement à base d'oxyde de silicium.

Le motif de grille 100 comprend typiquement une grille 21 et un masque dur 23 en nitrure, et typiquement du nitrure de silicium (SiN). Il peut présenter une largeur dite dimension critique comprise entre 10 nm et 100 nm et de préférence inférieure ou égale à 50 nm.

Le motif de grille peut présenter une hauteur de l'ordre de quelques dizaines de nanomètres. La grille 21 présente typiquement une hauteur inférieure ou égale à 100 nm, par exemple environ égale à 50 nm. La hauteur du masque dur 23 est généralement comprise entre 40 et 80 nanomètres.

Deux motifs de grille voisins sont séparés par un pas « p » typiquement inférieur ou égal à 120 nm.

Ils peuvent s'étendre selon des directions transverses aux directions d'extension principales des zones actives 11 et STI 12 (figure 1). En particulier, un même motif de grille 100 peut surmonter alternativement une ou plusieurs zones actives 11 et une ou plusieurs tranchées STI 12 adjacentes.

Des espaceurs 22 sont formés le long des flancs de ce motif de grille 1. Les flancs des motifs de grille s'étendent selon des plans sensiblement normaux au plan de base du substrat.

De façon connue, la formation de ces espaceurs 22 comprend généralement un dépôt conforme d'une couche de SiN sur et entre les motifs de grille 1, suivi d'une gravure anisotrope du SiN, selon une direction sensiblement parallèle aux flancs des motifs de grille.

Le dépôt peut typiquement se faire par PEALD, de façon à former une couche de SiN présentant une épaisseur inférieure ou égale à 15 nm, par exemple comprise entre 6 nm et 15 nm, de préférence entre 8 nm et 12 nm.

Alternativement au SiN, un matériau diélectrique de type Low-k (de constante diélectrique k<7) peut être utilisé pour former les espaceurs 22. Par exemple et non limitativement, ce matériau peut être du SiBCN ou du SiCO. La « couche en SiN » à laquelle il est fait référence par souci de clarté peut donc s'entendre de « la couche en un matériau diélectrique de type low-k utilisé pour former les espaceurs 22 ».

La gravure anisotrope est configurée pour consommer les portions de couche en SiN situées au sommet des motifs de grille 100 et entre les motifs de grille 100, sur une partie des zones 12. Elle peut être réalisée par plasma, par exemple à base d'une chimie de type fluorocarbonée, dans un réacteur plasma à couplage inductif ICP (Inductively Coupled Plasma).

Le facteur de forme des motifs de grille 100 induit généralement une consommation plus rapide des portions de couche à la base des motifs de grille, sur le substrat, par rapport aux portions de couche au sommet des motifs de grille.

Cela induit un phénomène de surgravure au niveau des zones exposées du substrat, notamment au niveau des zones exposées des STI 12.

Dès lors, des cavités 13 se forment en surface des tranchées STI 12 exposées.

Lors des étapes de fabrication classiques suivantes (notamment retrait du masque dur 23, dopage par implantation des zones actives pour la fabrication des source et drain, et épitaxies éventuelles au niveau des zones actives par exemple pour la fabrication de source et drain surélevés dits RSD ou « Raised Source Drain »), ces cavités 13 peuvent se développer et leur profondeur peut augmenter. Les étapes suivantes peuvent comprendre des recuits haute température.

En particulier, un recuit de diffusion et/ou d'activation des dopants implantés lors de la deuxième implantation ionique, souvent appelé « spike anneal », peut être effectué.

Tel qu'illustré à la figure 4, une couche de protection de préférence en SiN est déposée puis gravée de façon anisotrope pour obtenir le résultat de la figure 5. Des portions latérales de la couche de protection sont ainsi conservées sur les flancs des premiers espaceurs 22 pour former un revêtement de protection 24. Ce dernier s'étend préférentiellement sur l'intégralité de la surface exposée des espaceurs 22.

Tel qu'illustré à la figure 6, une étape de siliciuration d'une portion 25 de la zone de grille peut également être effectuée.

Cette étape comprend le dépôt d'un métal, par exemple du nickel (Ni), sur le sommet des grilles 21, et plusieurs recuits thermiques visant notamment à faire diffuser le métal dans la grille (recuit de diffusion) pour former un siliciure (NiSi ou NiPtSi) et à passiver les défauts électriquement actifs (recuit d'activation de type DSA, acronyme de « Dynamic Surface Anneal »). Le résultat est un module de contact 25, limitant la résistivité électrique.

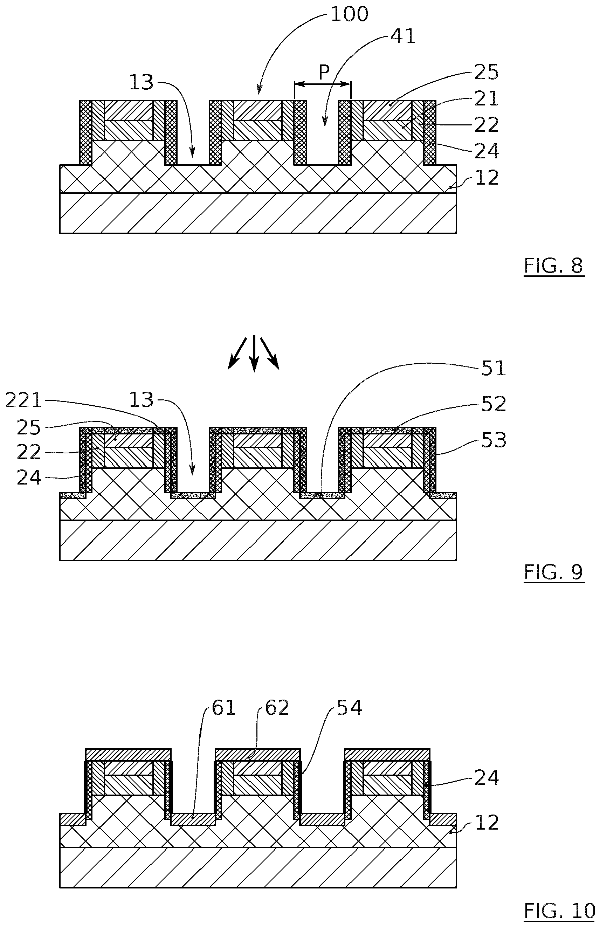

La figure 8 reflète une configuration du composant à ce stade, configuration dans laquelle le revêtement de protection 24 occupe un espace latéral non négligeable, s'étendant latéralement depuis les espaceurs 22 et couvrant la paroi des cavités 13 qui se sont formées au cours des étapes précédentes. L'espace interstitiel entre deux transistors adjacents se retrouve réduit par cette couche de protection, et le rapport de forme de cette zone, notamment en fond de cavité 13, est accru, ce qui est dommageable pour des étapes de dépôt de couches ultérieures.

Dans ce contexte, la présente invention cherche à réduire l'extension latérale du revêtement de protection 24, voire de la supprimer.

Suivant un mode de réalisation, le procédé de l'invention comprend une étape d'implantation permettant de former des parties superficielles modifiées des surfaces exposées. La figure 9 présente une telle modification, en particulier avec une partie modifiée 51 de la portion de base (formée par une surface exposée du matériau de la zone d'isolation électrique 12), de la cavité 13, une partie modifiée 52 du module de contact 25 et une partie modifiée 53 du revêtement de protection 24. De manière mineure, la tranche 221 exposée en face supérieure des espaceurs 22 peut aussi s'en trouver modifiée.

De préférence, cette implantation s'effectue avec des ions légers, c'est-à-dire présentant des numéros atomiques faibles, de préférence égale à un ou à deux. À cet effet, les espèces préférentielles sont à base d'hydrogène et d'hélium. Il peut s'agir de dihydrogène et/ou d'hélium ou un mélange des deux, ou encore d'autres composés comprenant de l'hydrogène et/ou de l'hélium, tel que du HBr ou du NH₃.

On s'arrange pour que cette phase d'implantation soit isotrope de sorte à produire une modification sur une épaisseur équivalente ou égale que ce soit sur les parties horizontales ou sur les parties verticales. Dans ce contexte, on peut utiliser un réacteur de gravure plasma de différents types et notamment de type « ICP » (de l'anglais inductively coupled plasma, c'est-à-dire plasma à couplage inductif), ou encore du type « CCP » (capacitively coupled plasma, c'est-à-dire plasma à couplage capacitif). On peut par ailleurs utiliser des plasmas par immersion.

On donne ci-après un exemple de paramètres particulièrement utilisables dans le contexte d'un réacteur ICP :
- pression : supérieure ou égale à 100 milli Torr, soit 0,1 x (101325/760)Pa ;
- température : supérieure ou égale à 100°C ;
- chimie : H₂.

Le temps de l'opération est avantageusement assez court de sorte à modifier une épaisseur faible. Ce temps peut être configuré pour que l'épaisseur modifiée soit inférieure ou égale à 5 nm, de préférence inférieure ou égale à 3 nm. Alternativement ou cumulativement, le temps de cette opération peut être inférieur ou égal à 30 secondes et/ou supérieur ou égal à 5 secondes, et préférentiellement inférieure ou égale à 10 secondes et/ou supérieur ou égal à 5 secondes.

La puissance de la source peut être comprise entre 100 et 2000 W, est par exemple 500 W et/ou la puissance de polarisation peut être comprise entre 20 et 2000 W, et par exemple 250 W. En termes de débit, on peut utiliser un flux d'hydrogène de 200 sccm (centimètres cubes par minute).

Sur la base de ces parties superficielles modifiées par l'implantation, on applique alors un plasma comprenant un mélange de composants gazeux.

Dans un mode de réalisation préféré, ce mélange comprend un premier composant qui inclut au moins une espèce chlorée et/ou au moins une espèce fluorée. On peut utiliser du SiCl₄, ou encore du SiF₄ notamment. Le premier composant a l'avantage de graver la partie superficielle modifiée 53 du revêtement de protection 24.

Dans le même temps, un aspect de l'invention est la formation d'une couche de protection sur les surfaces exposées pour lesquelles une gravure n'est pas souhaitée, en particulier au niveau des parties horizontales correspondant à la surface exposée du module de contact 25 et à la portion de base 41 des cavités 13. À ce sujet, un aspect de l'invention est de jouer sur la propension de formation d'une couche d'un oxyde de silicium sur des matériaux employés pour le module de contact 25 et pour la zone d'isolation électrique, alors que cette formation est nettement moins rapide, voire presque inexistante, sur le matériau du revêtement de protection 24, même modifié (dans ce contexte, la figure 10 n'illustre pas de couche d'oxyde au niveau du revêtement de protection 24).

Par exemple, dans les conditions d'application détaillées de plasma données ci-dessous, et après la phase d'implantation dans les conditions détaillées données ci-dessus, on peut parvenir à créer une couche d'un oxyde de silicium entre 3 et 4 fois plus épaisse sur le module de contact (typiquement à base de NiSi) et sur le matériau isolant de la cavité 13 (typiquement du SiO₂) que sur le revêtement de protection (typiquement du SiN). Suivant un mode de réalisation, l'application du plasma est configurée pour que la formation de la couche d'oxyde sur le revêtement de protection soit au maximum de 2 nm.

Ainsi, lors de l'application du mélange gazeux par plasma, une couche d'un oxyde de silicium, de forme générale SiOₓ, va se former prioritairement sur les surfaces 52 et 51 illustrées à la figure 9. L'action conjuguée de la gravure des parties modifiées du revêtement de protection 53 et de la formation d'une couche d'oxyde de silicium apparaît sur la figure 10. On remarque alors qu' une partie résiduelle 54 du revêtement de protection 24 est préservée et qu'une couche d'oxyde de silicium 61, 62 est présente à l'emplacement initial du revêtement de protection 24. On comprend que la couche d'oxyde de silicium assure une passivation des surfaces considérées de sorte à les rendre insensibles à la gravure ciblant le revêtement de protection 24.

Dans un mode de réalisation, le mélange gazeux comprend au moins un composant incluant l'espèce oxygène. Il s'agit typiquement de dioxygène O₂ servant par ailleurs au réglage de la dilution des autres composants du mélange.

Suivant un autre aspect, le mélange gazeux comprend avantageusement un gaz fluorocarboné, et plus préférentiellement un gaz hydrofluorocarboné, de formule générale CₓH_{y}F_{z}. Suivant un aspect, ce gaz renforce l'action de gravure de la partie modifiée du revêtement de protection 24. Il peut aussi servir à attaquer la partie résiduelle de ce revêtement de protection, lorsque la partie modifiée a complètement été enlevée.

On donne ci-après un exemple détaillé de l'application d'un tel plasma. On peut utiliser un réacteur correspondant à l'un des types indiqués précédemment pour la phase d'implantation. Préférentiellement, l'étape d'implantation et l'étape d'application de plasma s'opèrent dans le même réacteur. C'est aussi préférentiellement le cas des étapes d'implantation et d'application additionnelles opérées ensuite et décrites plus loin.

En l'occurrence, sur la base de l'emploi d'un réacteur de type ICP, les conditions suivantes peuvent être mises en oeuvre :
- pression : entre 10 et 80 milli Torr, soit entre 0,01 x (101325/760)Pa et 0,08 x (101325/760)Pa ;
- température : entre 10 et 100°C ;
- puissance de la source : entre 100 et 1000 W ;
- tension de polarisation : entre 50 V et 500 V ;
- fréquence de fonctionnement : 200 Hz à 5 kHz, avec un cycle de travail par exemple compris entre 20 % et 100 % ;
- durée : inférieure à 20 secondes, de préférence supérieure à 5 secondes, et de préférence inférieure ou égale à 10 secondes ;
- mélange de gaz :
   - gaz hydrofluorocarboné CxHyFz avec un débit compris entre 10 sccm et 500 sccm ;
   - O2 avec un débit compris entre 10 sccm et 1000 sccm ;
   - SiCl4 ou SiF4 avec un débit compris entre 5 et 15 sccm.

Au regard du résultat fourni à la figure 10, l'extension latérale du revêtement de protection 24 a été sensiblement diminuée, puisque seule une partie résiduelle 54 subsiste. Si la couche 24 initiale est suffisamment fine au regard des conditions de gravure, elle peut être supprimée totalement à ce stade.

Cependant, grâce à un aspect préférentiel de l'invention, il est possible de poursuivre précisément cet enlèvement en mettant en œuvre un cycle supplémentaire, pour le moins, d'implantation et d'application de plasma, préférentiellement en utilisant les paramètres précédemment décrits.

La répétition de ces étapes permet d'éliminer progressivement le revêtement de protection 24 en évitant un dépôt trop épais de l'oxyde de silicium sur ce revêtement de protection, ce qui pourrait intervenir si une seule étape d'application de plasma était mise en œuvre. En effet, l'implantation additionnelle est avantageusement configurée pour attaquer la couche d'oxyde de silicium ; cette attaque permet de réduire l'épaisseur sur les parties horizontales et, préférentiellement, de supprimer complètement la couche d'oxyde de silicium sur les parties verticales, c'est-à-dire au niveau du revêtement de protection 24.

On peut ajuster les temps d'implantation et d'application de plasma pour limiter les épaisseurs traitées.

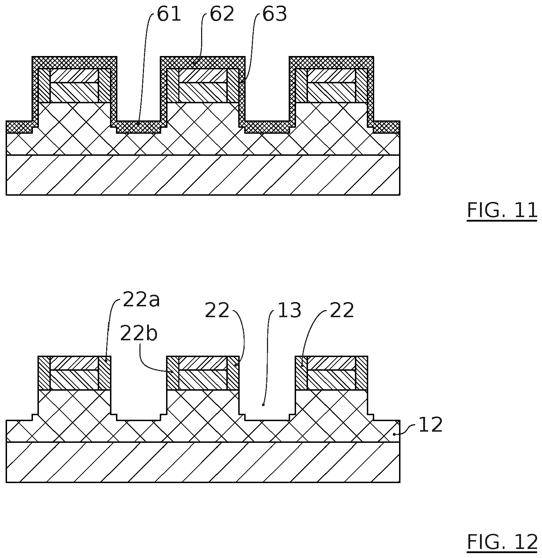

La figure 11 montre le résultat d'une implantation additionnelle permettant de former de nouvelles parties modifiées dont une nouvelle partie modifiée au niveau du revêtement de protection et d'une application additionnelle d'un plasma. Dans cet exemple, il n'y a plus de partie résiduelle du revêtement de protection 24 non modifiée ; cela signifie que lors de l'étape d'application additionnelle de plasma, l'ensemble du revêtement de protection a été enlevé. Cette fois, pour l'exemple, une couche d'oxyde 63 a été représentée sur les parties verticales.

Les figures illustrent la réalisation d'un seul cycle supplémentaire d'implantation et de gravure par plasma. Cependant, cet exemple de principe n'est pas limitatif et on peut opérer plusieurs cycles pour consommer progressivement le revêtement de protection 24.

La figure 12 montre le résultat après au moins une implantation additionnelle et au moins une application additionnelle de plasma, et après une étape de nettoyage final. Cette étape est configurée pour enlever la couche d'oxyde de silicium pouvant subsister, en particulier au niveau des surfaces de la portion de base de la cavité 13 et de la face supérieure du module de contact 25, comme cela était le cas la figure 11, sous les repères 61 et 62.

Dans ce contexte, un mode de réalisation consiste à employer une gravure humide, par exemple à base d'acide fluorhydrique. De préférence, la solution de gravure est fortement diluée de sorte à supprimer l'oxyde de silicium qui avait été déposé, sans attaquer, ou le moins possible, les couches sous-jacentes, et en particulier le matériau de la zone d'isolation électrique 12.

Le résultat reflété à la figure 12 est une succession de transistors entre lesquels les distances entre les espaceurs 22 de transistors différents ont été augmentées, sans pour autant creuser les cavités 13, de sorte que le rapport de forme obtenu à cet endroit est réduit et est bien plus favorable aux étapes suivantes, et en particulier à l'étape de formation d'une couche mécaniquement contraignante. La formation de vides est fortement réduite, voire complètement supprimée.

Le dépôt du stress liner (c'est-à-dire la couche mécaniquement contraignante) peut ensuite être effectué (non illustré) en limitant l'apparition de vides résiduels.

Typiquement, le stress liner est une couche de nitrure, en particulier une couche de nitrure de silicium (SiN ou SixNy x et y étant des entiers).

Il peut être déposé de façon conforme par l'une des techniques suivantes : dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt thermique CVD rapide (RTCVD, acronyme de rapid thermal CVD), dépôt physique en phase vapeur (PVD, acronyme de physical vapor déposition), dépôt par couche atomique (ALD, acronyme de atomic layer déposition). D'autres types de dépôts peuvent être envisagés.

Le stress liner peut présenter une épaisseur de quelques nanomètres à quelques dizaines de nanomètres, et notamment une épaisseur comprise entre 5 et 40 nanomètres, par exemple 20 nm.

Il n'est pas exclu de déposer une pluralité de stress liner ou de limiter le dépôt du stress liner à une zone de la face du substrat, et, éventuellement, de revêtir au moins une autre zone de la face du substrat par au moins un autre stress liner, par exemple pour mettre en œuvre des contraintes mécaniques de signes opposés (en compression et en tension).

Un intérêt de l'invention est d'accroître la fiabilité de fabrication des transistors.

Les étapes ultérieures de formation des contacts électriques sur les zones électriquement actives des transistors (zones source/drain et grille) peuvent notamment se faire sans risque de court-circuit entre deux zones actives 11 lié à un remplissage intempestif d'un vide résiduel au niveau des STI 12.

## Revendications

1. Procédé de réalisation d'un composant à base d'une pluralité de transistors, sur un substrat comprenant une zone active (11) et une zone d'isolation électrique (12), chaque transistor de la pluralité de transistors comprenant une grille (21), des espaceurs (22) sur les flancs de la grille (21) et un module de contact (25) sur une face supérieure de la grille (21), la zone d'isolation électrique (12) comprenant au moins une cavité (13) formée en creux entre un espaceur (22a) d'un premier transistor de la pluralité de transistors et un espaceur (22b) d'un deuxième transistor de la pluralité de transistors, lesdits premier transistor et deuxième transistor étant adjacents, le procédé comprenant :
- une formation d'une zone de grille (100) des transistors,
- une formation des espaceurs (22),
- une formation d'un revêtement de protection (24) configuré pour recouvrir au moins en partie les espaceurs (22) et une portion de flanc des cavités (13), sans recouvrir une face supérieure de la zone de grille (100) et une portion de base des cavités (13),
- une formation du module de contact (25) dans une portion supérieure de la zone de grille (100) à partir de sa face supérieure, la grille (21) se trouvant dans une portion de la zone de grille sous-jacente au module de contact (25),
le procédé étant **caractérisé en ce qu'**il comprend après la formation du module de contact (25), un enlèvement d'au moins une partie du revêtement de protection (24), avec :
- une implantation isotrope d'ions légers configurée pour former des parties superficielles modifiées (52, 53, 51) dans l'épaisseur respectivement, du module de contact (25), du revêtement de protection (24) et de la portion de base (41) de la cavité (13) ;
- une application d'un plasma comprenant au moins un mélange de composants gazeux, l'application d'un plasma étant configurée pour :
i. graver la partie superficielle modifiée (53) du revêtement de protection (24) de sorte à ne préserver, dans le revêtement de protection (24), qu'une partie résiduelle (54) du revêtement de protection (24) ;
ii. former une couche à base d'un oxyde de silicium sur les surfaces exposées, respectivement, du module de contact (25), de la cavité (13) et du revêtement de protection (24), et pour que la couche d'un oxyde de silicium soit plus épaisse sur la surface exposée du module de contact (25) et sur celle de la cavité (13) que sur la surface exposée du revêtement de protection (24).

2. Procédé selon la revendication précédente, comprenant après l'application du plasma :
- une implantation isotrope d'ions légers additionnelle, configurée pour supprimer la couche à base d'un oxyde de silicium sur la surface exposée du revêtement de protection tout en préservant au moins une partie de l'épaisseur de la couche à base d'un oxyde de silicium sur la surface exposée du module de contact et sur celle de la cavité, et configurée pour former une nouvelle partie superficielle modifiée de la surface exposée de la partie résiduelle du revêtement de protection ;
- une application additionnelle du plasma, configurée pour graver la nouvelle partie superficielle modifiée de la partie résiduelle du revêtement de protection, de manière sélective relativement aux parties modifiées de la couche d'oxyde de silicium, respectivement, sur la surface exposée du module de contact (25) et sur celle de la cavité (13).

3. Procédé selon la revendication précédente, comprenant au moins un cycle supplémentaire d'opération de l'implantation isotrope additionnelle et de l'application additionnelle.

4. Procédé selon l'une quelconque des revendications précédentes, dans lequel on utilise un plasma dans lequel le mélange de composants gazeux comprend au moins un premier composant gazeux et un deuxième composant gazeux, et dans lequel le premier composant gazeux est configuré pour graver la partie superficielle modifiée du revêtement de protection de sorte à ne préserver, dans le revêtement de protection (24), que la partie résiduelle du revêtement de protection, et dans lequel le deuxième composant gazeux est configuré pour graver au moins une partie de la partie résiduelle du revêtement de protection (24).

5. Procédé selon la revendication précédente, dans lequel le deuxième composant gazeux comprend au moins une espèce fluorocarbonée, dont, de préférence, au moins une espèce hydrofluorocarbonée.

6. Procédé selon l'une quelconque des deux revendications précédentes, dans lequel le premier composant gazeux comprend du SiCl4 et/ou du SiF4.

7. Procédé selon l'une quelconque des revendications précédentes, dans lequel le mélange de composants gazeux comprend du dioxygène.

8. Procédé selon l'une quelconque des revendications précédentes, dans lequel les ions légers comprennent des espèces choisies parmi des ions à base d'hydrogène et/ou d'hélium.

9. Procédé selon la revendication précédente, dans lequel l'implantation isotrope est effectuée par l'application d'un plasma comprenant les ions légers à une pression supérieure ou égale à 100 milli Torr, soit 0,1 x (101325/760)Pa, sous une température inférieure ou égale à 100 °C.

10. Procédé selon la revendication précédente, dans lequel la durée d'implantation isotrope est inférieure ou égale à 30 secondes, et de préférence moins de 10 secondes.

11. Procédé selon l'une quelconque des revendications précédentes, dans lequel le revêtement de protection (24) est formé à base de nitrure de silicium.

12. Procédé selon l'une quelconque des revendications précédentes, dans lequel l'implantation isotrope, l'application du plasma, l'implantation isotrope additionnelle et l'application additionnelle du plasma sont opérées dans un même réacteur.

13. Procédé selon l'une quelconque des revendications précédentes, comprenant, après l'enlèvement d'au moins une partie du revêtement de protection (24), une formation d'une couche mécaniquement contraignante (15) pour les transistors.

14. Procédé selon la revendication précédente, configuré pour enlever entièrement le revêtement de protection (24) avant la formation de la couche mécaniquement contraignante (15).

15. Procédé selon l'une quelconque des deux revendications précédentes, comprenant, après l'enlèvement d'au moins une partie du revêtement de protection (24) et avant la formation de la couche mécaniquement contraignante (15), une gravure configurée pour supprimer la couche d'un oxyde de silicium
